# EUROPEAN PATENT APPLICATION

(11) **EP 4 468 535 A1**
(43) Date of publication of application: **27.11.2024**
(21) Application number: 22922302.9
(22) Date of filing: 30.06.2022
(51) Int. Cl.: H01R 13/646, H01R 24/38, H01R 103/00

(54) **PLUG AND ADAPTOR FOR RF COAXIAL CABLE AND RF CONNECTOR ASSEMBLY COMPRISING SAME**

(30) Priority: 20.01.2022 KR 20220008731
(71) Applicant: SENSORVIEW CO., LTD., Gyeonggi-do 13493 (KR)
(72) Inventor: KIM, Byoung Nam, Bucheon-si, Gyeonggi-do 14549 (KR); KANG, Kyoung Il, Suwon-si, Gyeonggi-do 16694 (KR); PARK, Joung Min, Osan-si, Gyeonggi-do 18113 (KR); LIM, Jong Hyup, Hwaseong-si, Gyeonggi-do 18499 (KR); KANG, Ji Hun, Hwaseong-si, Gyeonggi-do 18484 (KR); CHUN, Ga Young, Hwaseong-si, Gyeonggi-do 18487 (KR)
(74) Representative: Pereira da Cruz, Joao
(86) International application number: PCT/KR2022/009377
(87) International publication number: WO 2023/140443

(57) **Abstract**

The present invention may provide a plug for an RF coaxial cable, to which the RF coaxial cable is coupled, comprising: a first body in which the RF coaxial cable is inserted; a first conductor disposed in the first body; a coupling nut which is arranged on the outside of the first body and rotatably coupled to the first body; and a first magnet of an annular shape which is fixed in the coupling nut and rotated along with the coupling nut, wherein the first magnet has a first pole and a second pole having different polarities which are alternately arranged in the circumferential direction.

## Description

### Technical Field

The present invention relates to a plug and adaptor for a radio frequency (RF) coaxial cable and an RF connector assembly comprising the same, and more specifically, to a plug and adaptor for an RF coaxial cable that can electrically connect a printed circuit board, an RF module, and a coaxial cable and facilitates performance testing, and an RF connector assembly comprising the same.

### Background Art

Generally, radio frequency (RF) connectors are used to connect RF coaxial cables to equipment and components such as exchange station equipment, base station equipment, repeaters, and antennas for wired and wireless communication to transmit and receive specific signals such as relatively high-frequency RF signals.

These RF coaxial cables are equipped with various types of coaxial connectors depending on their use and the frequency of the signals, and connectors manufactured to suit the structural characteristics of the connecting parts are selected and used. Types of RF connectors include DIN-Type, N-Type, BNC-Type, TNC-Type, SMA-Type, and the like. These classifications are based on the shape of the connector, the type of cable, the frequency range of the signal, the coupling method, etc.

Typically, an adaptor is connected to a testing device to test the performance of an RF coaxial cable and a plug assembly. The adaptor and the plug are generally fastened to each other by screw coupling.

However, when using such a conventional RF connector assembly, testing the plug to which the RF coaxial cable is connected requires screwing the plug to the adaptor for each test and then unscrewing the adaptor and the plug after the test, which becomes cumbersome and time-consuming when testing multiple plug-cable assemblies due to the coupling and uncoupling of the adaptor and plug.

### Detailed Description of the Invention

### Technical problem

The present invention has been conceived to solve the aforementioned problems, and aims to provide a plug and adaptor for a radio frequency (RF) coaxial cable capable of reducing the testing time of an RF connector by facilitating the coupling and uncoupling of an adaptor and a plug to which an RF coaxial cable is coupled, as well as an RF connector assembly including the same.

The objects to be achieved by the present invention are not limited to the foregoing object, and additional objects, which are not mentioned herein, will be readily understood by those skilled in the art from the following description.

### Technical Solution

In one embodiment, there is provided a plug for a radio frequency (RF) coaxial cable, to which an RF coaxial cable is coupled, including: a first body in which the RF coaxial cable is inserted; a first conductor disposed in the first body; a coupling nut which is arranged on the outside of the first body and rotatably coupled to the first body; and a first magnet of an annular shape which is fixed in the coupling nut and rotated along with the coupling nut, wherein the first magnet has a first pole and a second pole having different polarities which are alternately arranged in the circumferential direction.

The first magnet may include a first groove disposed at a boundary between the first pole and the second pole, and the first groove may be disposed on an outer peripheral surface of the first magnet and may extend to a front surface of the first magnet.

The plug may further include a first shield member of an annular shape, and the first shield member may be in contact with a rear surface of the first magnet.

The coupling nut may include a first step disposed on an inner surface, and the rear surface of the first shield member may be in contact with the first step.

The first magnet may include a second groove disposed on an edge formed between a front surface of the first magnet and an outer peripheral surface of the first magnet and may further include a first press-fit ring disposed in the second groove, and an inner peripheral surface of the first press-fit ring may be in contact with the first magnet while an outer peripheral surface of the first press-fit ring may be in contact with an inner peripheral surface of the coupling nut, thereby fixing the first magnet to the coupling nut.

The first magnet may include a first hole that penetrates through a front surface of the first magnet and a rear surface of the first magnet, the coupling nut may include a third groove disposed on an inner surface of the coupling nut and arranged in alignment with the first hole, and a first press-fit ring may be press-fit into the first hole and the third groove, thereby fixing the first magnet to the coupling nut.

In one embodiment, there is provided an adaptor for an RF coaxial cable to which an RF coaxial cable is coupled, including a second body, a second conductor disposed in the second body, and a second magnet of an annual shape which is fixed to the outside of the second body, wherein the second magnet has a first pole and a second pole having different polarities which are alternately arranged in the circumferential direction.

The second magnet may include a third groove disposed at a boundary between the first pole and the second pole, and the third groove may be disposed on an outer peripheral surface of the second magnet and may extend to a front surface of the second magnet.

The adaptor may further include a second shield member of an annular shape, and the second shield member may be in contact with a rear surface of the second magnet.

The body may include a second step, and the rear surface of the second shield member may be in contact with the second step.

The second magnet may include a fourth groove disposed on an edge formed between a front surface of the second magnet and an inner peripheral surface of the second magnet; and
may further include a second press-fit ring disposed in the fourth groove.

An inner peripheral surface of the second press-fit ring may be in contact with the second body while an outer peripheral surface of the second press-fit ring may be in contact with an inner peripheral surface of the second magnet, thereby fixing the second magnet to the second body.

The second magnet may include a second hole that penetrates through front and rear surfaces of the second magnet.

The second body may include a fifth groove arranged in alignment with the second hole.

A second press-in pin may be press-fit into the second hole and the fifth groove, thereby fixing the second magnet to the second body.

In an RF connector assembly, when the plug and the adaptor are coupled, the first magnet and the second magnet may be arranged to face each other, and with the rotation of the coupling nut, when the first pole of the first magnet and the second pole of the second magnet are aligned in the circumferential direction, the plug and the adaptor are coupled by an attractive force between the first magnet and the second magnet, and when the first pole of the first magnet and the first pole of the second magnet are aligned in the circumferential direction, the plug and the adaptor are separated by a repulsive force between the first magnet and the second magnet.

In the plug, the coupling nut may include an inner part rotatably coupled to the outer surface of the first body and an outer part disposed outside the inner portion and slidably coupled to the inner part in the front-and-rear direction, a separation leading portion which is elastically deformably fixed to the inner part and comprises a tip portion aligned between the first magnet and the second magnet in the front and rear direction, the separation leading portion may be disposed so as to contact an inner surface of the outer part that slides, and when the coupling nut moves rearward, the coupling nut may push the separation leading portion, causing the tip portion to move in the radial direction, so that the tip portion is inserted between the first magnet and the second magnet in the front and rear direction, thereby separating the first magnet and the second magnet.

The plug further may further include an elastic member disposed between the outer part and the inner part in the front and rear direction, which provides a restoring force when compressed; when the coupling nut is pulled rearward, the elastic member may remain compressed and provide a restoring force, pushing the separation leading portion to move the tip portion between the first magnet and the second magnet, and when the coupling nut is pulled rearward and then released, the separation leading portion may return to its position before elastic deformation due to the restoring force.

An inner surface of the coupling unit may include a first surface in contact with the separation leading portion, the first surface may be formed to have an inner diameter that increases toward the rear, and the separation leading portion may be disposed inside the elastic member in the radial direction.

The second body may include a sixth groove which is recessed from a front surface of the second body, and the first body may include a first protrusion portion which is inserted into the sixth groove.
a seventh groove recessed from the sixth groove and a second protrusion portion which protrudes from the first protrusion portion and is inserted into the seventh groove.

The first protrusion portion may be composed of a plurality of first elastic segments spaced apart from each other in the circumferential direction, each of the plurality of first elastic segments may include a locking protrusion protruding in the radial direction, and an inner surface of the sixth groove may include a locking groove that engages with the locking protrusion.

The second body may include a third protrusion portion protruding from a front surface of the second body, the first body may include a seventh groove recessed from a front surface of the first body, and the third protrusion portion may be composed of a plurality of second elastic segments that are spaced apart from each other in the circumferential direction and inserted into the seventh groove.

### Advantageous Effects

According to the embodiment, a plug and adaptor for a radio frequency (RF) coaxial cable and an RF connector assembly comprising the same have the advantage of easily coupling or uncoupling the plug and the adaptor solely through magnetic attraction, without the need for screw coupling between the plug and the adaptor.

According to the embodiment, the polarities of the magnets of the plug and adaptor facing each other are made the same or opposite in conjunction with the rotation of the coupling nut, the plug and the adaptor can be easily coupled or uncoupled by simply rotating the coupling nut.

According to the embodiment, pulling the coupling nut rearward causes a separation leading portion to elastically deform and enter between the magnets of the plug and adaptor, physically separating the magnet of the plug and the magnet of the adaptor and thereby easily uncoupling the plug and the adaptor.

According to the embodiment, one side of the body of the plug or the body of the adaptor includes a protruding structure with elastic segments that elastically contract or expand, while the other side has a structure to accommodate and couple with it, which ensures additional coupling force between the plug and the adaptor, in addition to magnetic force, and provides shielding performance.

### Brief Description of Drawings

FIG. 1 is a side cross-sectional view showing a radio frequency (RF) connector assembly according to an embodiment;
FIG. 2 is a view showing a plug shown in FIG. 1;
FIG. 3 is a plan view showing a first magnet;
FIG. 4 is a view showing an adaptor shown in FIG. 1;
FIG. 5 is a plan view showing a second magnet;
FIG. 6 is a side cross-sectional view showing the connector assembly before the plug and adaptor are coupled;
FIG. 7 is a view showing the plug in which the first magnet is fixed through a first press-fit ring;
FIG. 8 is a view showing the adaptor in which the second magnet is fixed through a second press-fit ring;
FIG. 9 is a side cross-sectional view showing the connector assembly before the plug of FIG. 1 and the adaptor of FIG. 8 are coupled;
FIG. 10 is a side cross-sectional view of the connector assembly, depicting the plug in which the first magnet is fixed to a coupling nut through the first press-fit pin and the adaptor in which the second magnet is fixed to a second body through the second press-fit pin;
FIG. 11 is a plan view of the first magnet including a first hole;
FIG. 12 is a plan view of the second magnet including a second hole;
FIG. 13 is a diagram illustrating the relative positions of the first magnet and the second magnet;
FIG. 14 is a side cross-sectional view of a connector assembly including a separation leading portion;
FIG. 15 is a side cross-sectional view of a connector assembly in which a plug and an adaptor are uncoupled by the separation leading portion.
FIG. 16 is a side cross-sectional view of a connector assembly including a plug and an adaptor that form a multi-step coupling relationship.
FIG. 17 is a side cross-sectional view of a connector assembly including a plug and an adaptor that form a coupling relationship of a tension structure included in the plug;
FIG. 18 is a view showing the connector assembly shown in FIG. 17, depicting the plug and the adaptor before coupling.
FIG. 19 is a side cross-sectional view of a connector assembly including a plug and an adaptor that form a coupling relationship of a tension structure included in the adaptor; and
FIG. 20 is a view showing the connector assembly shown in FIG. 19, depicting the plug and adaptor before coupling.

### Mode for Invention

Objects, features, and advantages of the present invention will become readily apparent by reference to the following detailed description when considered in conjunction with the accompanying drawings. Also, terms or words used herein should not be construed as having common or dictionary meanings, but should be construed as having meanings and concepts that comply with the technical spirit of the present invention on the basis of the principle that the inventor may appropriately define the concepts of the terms in order to best describe his or her invention. In addition, descriptions and details of well-known features and techniques may be omitted to avoid unnecessarily obscuring the discussion of the described embodiments of the invention.

In describing the elements of this specification, terms, such as the first, second, A, B, a, and b, may be used. However, the terms are used to only distinguish one element from other elements, but the essence, order, and sequence of the elements are not limited by the terms.

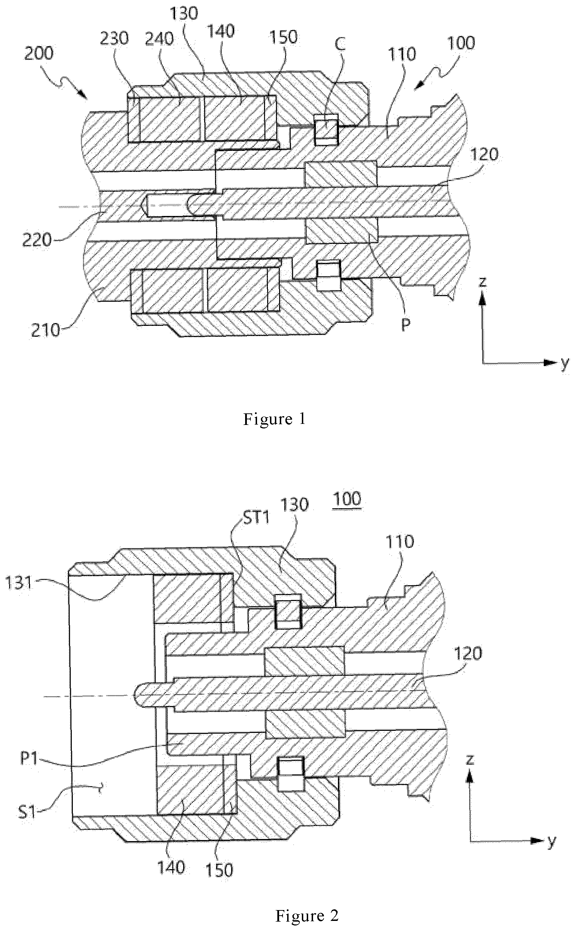

FIG. 1 is a side cross-sectional view showing a radio frequency (RF) connector assembly according to an embodiment. Hereinafter, in the drawings, the x-axis represents an axial direction of an RF connector assembly and the z-axis represents the radial direction of the RF connector assembly. Hereinafter, the terms "forward," "front," "rearward," and "rear," or "back" are based on the axial direction. From the perspective of the plug, the direction from the plug towards the adaptor refers to a forward direction and the opposite direction refers to a rearward direction. From the perspective of the adaptor, the direction from the adaptor towards the plug refers to a forward direction, and the opposite direction refers to a rearward direction. Hereinafter, the terms "inner" and "outer" are based on the radial direction.

Referring to FIG. 1, the RF connector assembly according to the embodiment may include a plug 100 and an adaptor 200. The plug 100 and the adaptor 200 are coaxially connected. A cable (not shown) may be connected to the plug 100. Since the plug 100 and the adaptor 200 are coupled by magnetic force, threads for connecting the plug 100 and the adaptor 200 may be omitted. The plug 100 includes a first magnet 140, and the adaptor 200 includes a second magnet 240. The first magnet 140 and the second magnet 240 are arranged to face each other.

FIG. 2 is a view showing the adaptor shown in FIG. 1.

Referring to FIGS. 1 and 2, the plug 100 may include a first body 110, a first conductor 120, a coupling nut 130, a first magnet 140, and a first shield member 150.

A cable may be inserted into the first body 110. The first body 110 may include a first protrusion portion P1. The first protrusion portion P1 may be formed to protrude forward from the front surface of the first body 110.

The first conductor 120 is disposed inside the first body 110. The first conductor 120 is provided for electrical connection with the adapt0r 200. An insulator may be disposed between the first body 110 and the first conductor 120 in the radial direction.

The coupling nut 130 may be arranged on the outside of the first body 110. The first body 110 and the first magnet 140 are disposed inside the coupling nut 130.

The coupling nut 130 may be rotatably coupled to the outer surface of the first body 110 around the axial center. For example, a C-ring C may be disposed between the inner peripheral surface of the coupling nut 130 and the outer peripheral surface of the first body 110, and the coupling nut 130 may rotate around the axial center of the first body 110 according to the user's operation.

The first magnet 140 is fixed inside the coupling nut 130. The first magnet 140 may be of an annular shape. The outer peripheral surface of the first magnet 140 may be in contact with the inner surface of the coupling nut 130. The first magnet 140 may be press-fit into the inner surface 131 of the coupling nut 130. The first protrusion P1 is located inside the first magnet 140. The front end of the first conductor 120 may protrude forward farther than the front end of the first magnet 140.

As the internal space of the coupling nut 130, the front of the first magnet 140 corresponds to a space S1 where the first magnet 140 of the adaptor 200 is accommodated.

The first shield member 150 is in contact with the rear surface of the first magnet 140. The first shield member 150 blocks the magnetic force of the first magnet 140 from flowing to the rear of the first magnet 140, causing the magnetic force that was flowing rearward to flow forward. The coupling nut 130 includes a first step ST1 disposed on the inner surface thereof. The rear surface of the first shield member 150 is in contact with the first step ST1.

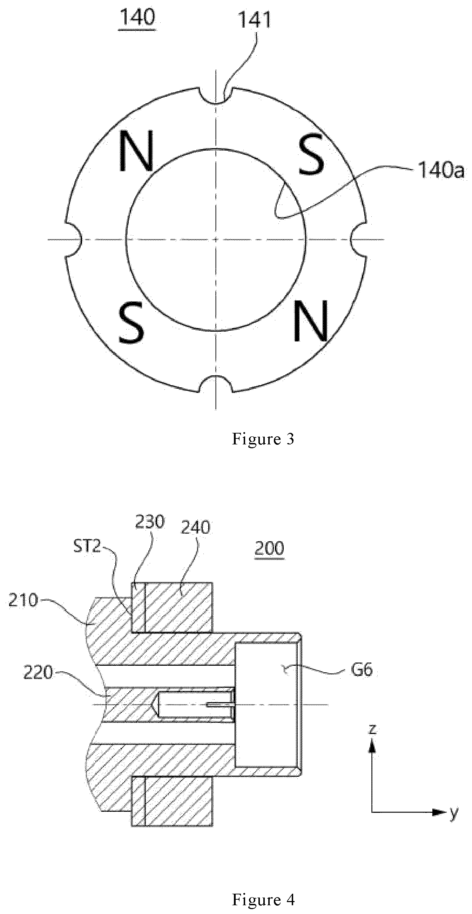

FIG. 3 is a plan view showing the first magnet 140.

Referring to FIG. 3, the first magnet 140 may be an annular member with a hole 140a formed in the center. The first magnet 140 may have a first pole N and a second pole S with different polarities that are alternately arranged in the circumferential direction. For example, the first magnet 140 may have four poles divided and arranged in the circumferential direction, with the first poles N and the second poles S alternately arranged along the circumferential direction. In the first magnet 140, the total volume occupied by the first poles N may be equal to the total volume occupied by the second poles S. The four poles may each occupy an equal total volume.

The first magnet 140 may include a 1-1 st groove 141. The 1-1 st groove 141 is disposed at the boundary between the first pole N and the second pole S. The 1-1st groove 141 is formed concavely on the outer peripheral surface of the first magnet 140. Also, the 1-1 st groove 141 extends to the front surface of the first magnet 140. This 1-1st groove 141 is provided to indicate the positions of the first pole N and the second pole S.

FIG. 4 is a view showing the adaptor shown in FIG. 1.

Referring to FIGS. 1 and 4, the adaptor 200 may include a second body 210, a second conductor 220, a second shield member 230, and a second magnet 240.

The second body 210 has a sixth groove G6 formed at the front end thereof. The sixth groove G6 is recessed from the front surface of the second body 210. When the plug 100 and the adaptor 200 are coupled, the first protrusion portion P1 of the plug 100 is inserted into the sixth groove G6.

The second conductor 220 is disposed inside the second body 210. The second conductor 220 is provided for electrical connection with the plug 100.

The second shield member 230 is in contact with the rear surface of the second magnet 240. The second shield member 230 blocks the magnetic force of the second magnet 240 from flowing to the rear of the second magnet 240. The coupling nut 130 includes a second step ST2 disposed on the inner surface thereof. The rear surface of the second shield member 230 is in contact with the second step ST2.

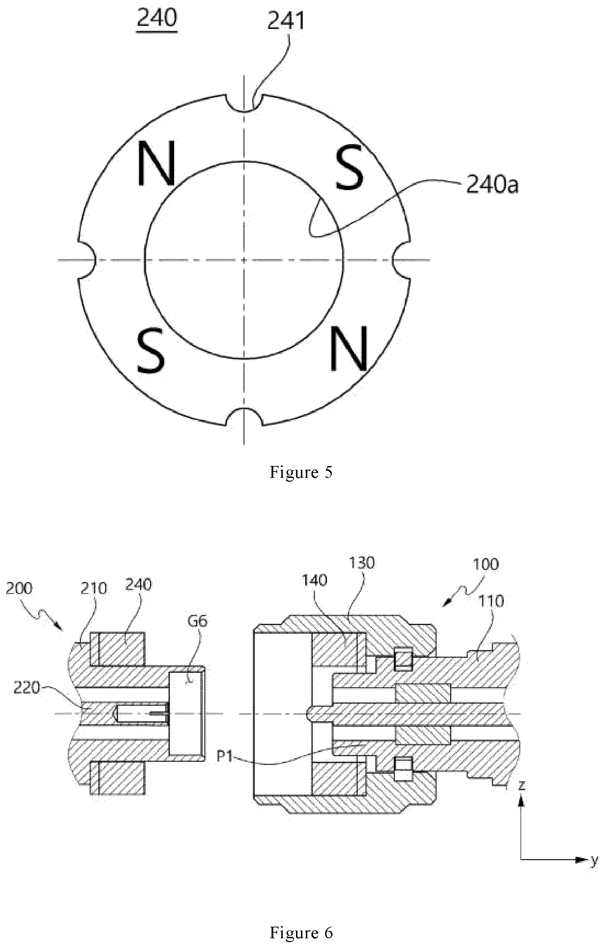

FIG. 5 is a plan view showing the second magnet 240.

Referring to FIG. 5, the first magnet 140 and the second magnet 240 may have the same size and shape. The second magnet 240 may be an annular member with a hole 240a formed in the center. The second magnet 240 may have a first pole N and a second pole S with different polarities that are alternately arranged in the circumferential direction. For example, the second magnet 240 may have four poles divided and arranged in the circumferential direction, with the first poles N and the second poles S alternately arranged along the circumferential direction.

In the second magnet 240, the total volume occupied by the first poles N may be equal to the total volume occupied by the second poles S. The four poles may each occupy an equal total volume.

The second magnet 240 may include a 1-2nd groove 241. The 1-2nd groove 241 is disposed at the boundary between the first pole N and the second pole S. The 1-2nd groove 241 is formed concavely on the outer peripheral surface of the first magnet 140. Also, the 1-2nd groove 241 extends to the front surface of the first magnet 140. This 1-2nd groove 241 is provided to indicate the positions of the first pole N and the second pole S.

FIG. 6 is a side cross-sectional view showing a connector assembly before the plug 100 and the adaptor 200 are coupled.

Referring to FIG. 6, when the plug 100 and the adaptor 200 are positioned coaxially, the first magnet 140 and the second magnet 240 are arranged to face each other. The plug 100 and the adaptor 200 are coupled or uncoupled using the magnetic force flowing between the first magnet 140 and the second magnet 240 without the need for threads for rotational coupling.

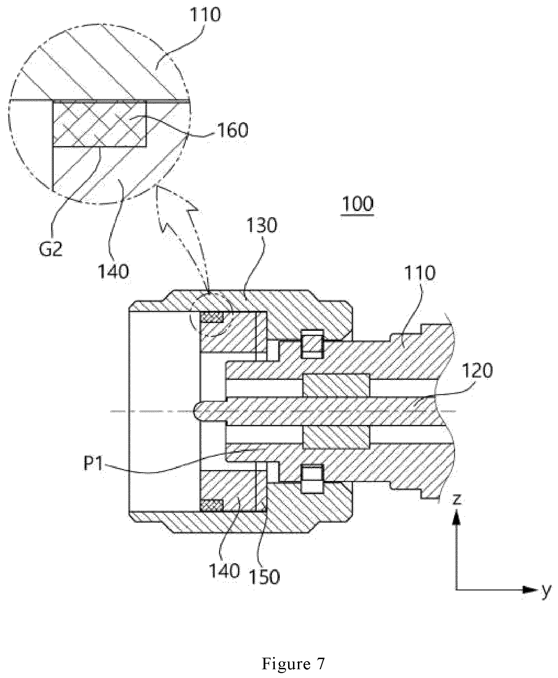

FIG. 7 is a view showing the plug 100 in which the first magnet 140 is fixed through a first press-fit ring 160.

Referring to FIG. 7, as an example, the first magnet 140 may be fixed to the coupling nut 130 through the first press-fit ring 160. The first magnet 140 may include a second groove G2. The second groove G2 may be disposed on the edge formed between the front surface of the first magnet 140 and the outer peripheral surface of the first magnet 140. The first press-fit ring 160 is press-fit into the space formed by this second groove G2 and the inner surface of the coupling nut 130.

When the first press-fit ring 160 is disposed in the second groove G2, the inner peripheral surface of the first press-fit ring 160 is brought into contact with the first magnet 140. The outer peripheral surface of the first press-fit ring 160 is in contact with the inner surface of the coupling nut 130.

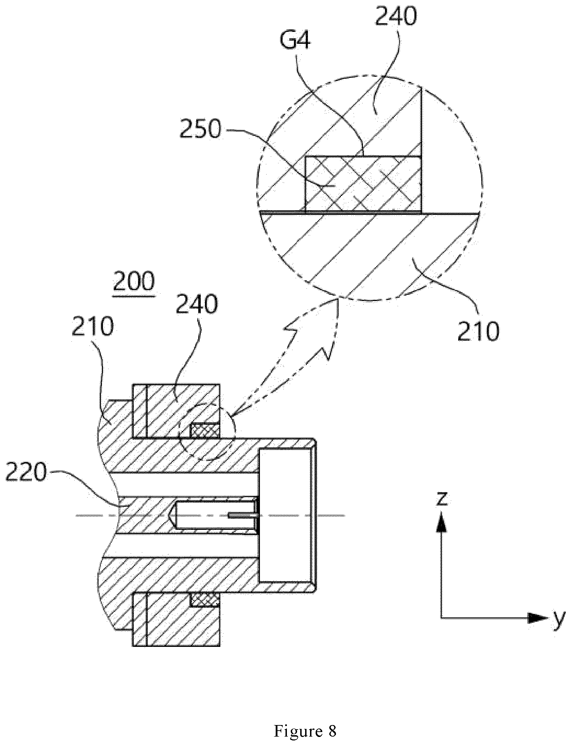

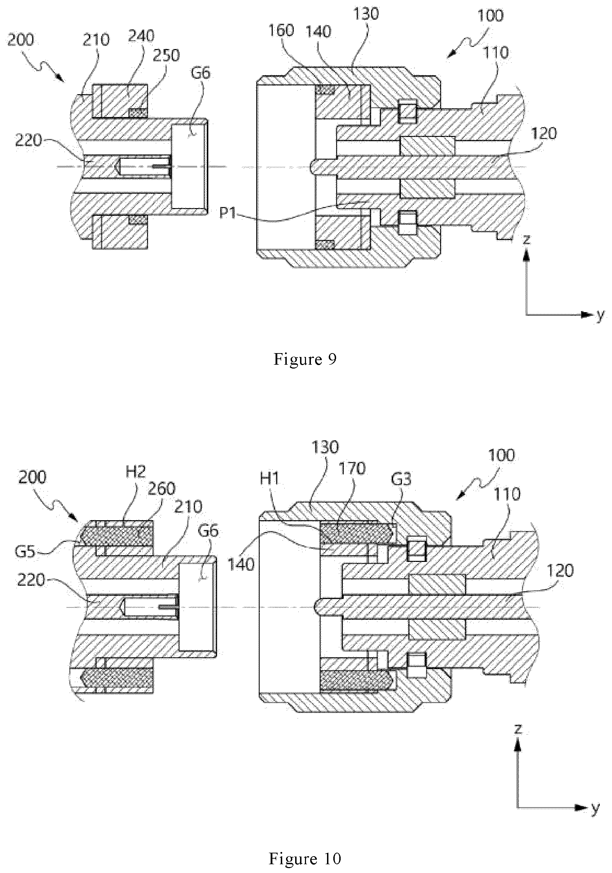

FIG. 8 is a view showing the adaptor 200 in which the second magnet 240 is fixed through a second press-fit ring, and FIG. 9 is a side cross-sectional view showing the connector assembly before the plug 100 of FIG. 7 and the adaptor 200 of FIG. 8 are coupled.

Referring to FIGS. 8 and 9, as an example, the second magnet 240 may be fixed to the second body 210 through the second press-fit ring 250.

The second magnet 240 may include a fourth groove G4. The fourth groove G4 may be disposed on the edge formed between the front surface of the second magnet 240 and the outer peripheral surface of the second magnet 240. The second press-fit ring 250 is press-fit into the space formed by this fourth groove G4 and the outer surface of the second body 210.

When the second press-fit ring 250 is disposed in the fourth groove G4, the outer peripheral surface of the second press-fit ring 250 is brought into contact with the second magnet 240. The inner peripheral surface of the second press-fit ring 250 is in contact with the outer peripheral surface of the second body 210.

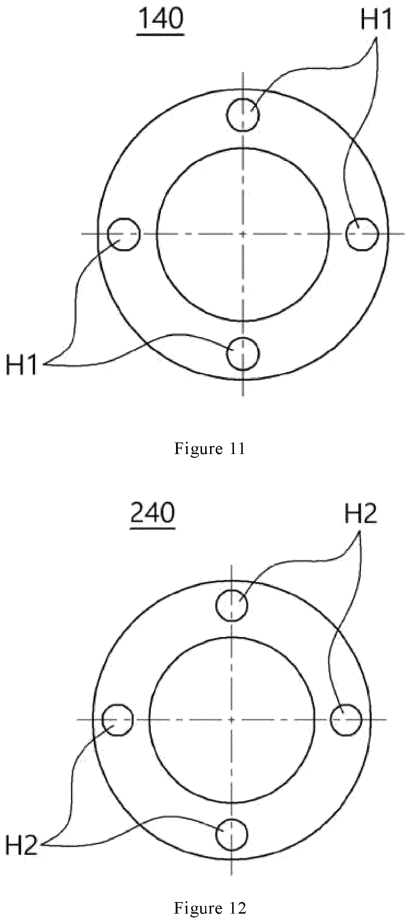

FIG. 10 is a side cross-sectional view of the connector assembly, showing the plug 100 in which the first magnet 140 is fixed to the coupling nut 130 through the first press-fit pin 170 and the adaptor 200 in which the second magnet 240 is fixed to the second body 210 through the second press-fit pin 260; FIG. 11 is a plan view of the first magnet 140 including a first hole H1; and FIG. 12 is a plan view of the second magnet 240 including a second hole H2.

Referring to FIGS. 10 and 11, as an example, the first magnet 140 may be fixed to the coupling nut 130 through the first press-fit pin 170.

The first magnet 140 may include the first hole H1. The first hole H1 may be arranged to penetrate through the front surface of the first magnet 140 and the rear surface of the first magnet 140. A plurality of first holes H1 may be arranged. For example, four first holes H1 may be arranged at regular intervals in the circumferential direction.

Meanwhile, the coupling nut 130 may include a third groove G3. The third groove G3 may be disposed on the inner surface of the coupling nut 130. The third groove G3 is disposed at the rear of the first magnet 140, and arranged in alignment with the first hole H1. The first press-fit pin 170 is press-fit into the first holes H1 and the third groove G3, thereby fixing the first magnet 140 to the coupling nut 130.

Referring to FIGS. 10 and 12, as an example, the second magnet 240 may be fixed to the second body 210 through the second press-fit pin 260.

The second magnet 240 may include the second hole H2. The second hole H2 may be arranged to penetrate through the front surface of the second magnet 240 and the rear surface of the second magnet 240. A plurality of second holes H2 may be arranged. For example, four second holes H1 may be arranged at regular intervals in the circumferential direction.

Meanwhile, the second body 210 may include a fifth groove G5. The fifth groove G5 is disposed at the rear of the second magnet 240, and arranged in alignment with the second hole H2.

The second press-fit pin 260 is press-fit into the second holes H2 and the third groove G3, thereby fixing the second magnet 240 to the second body 210.

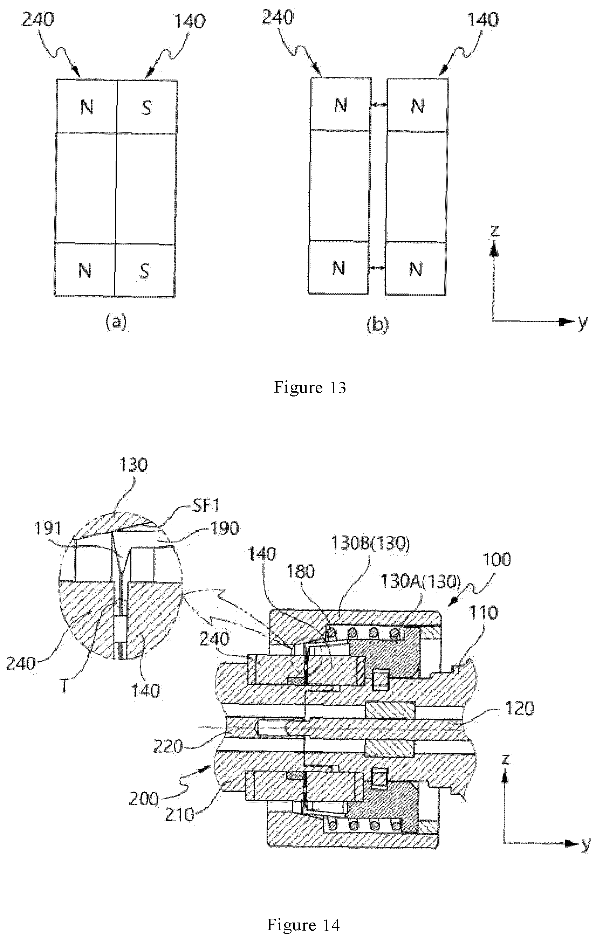

FIG. 13 is a diagram illustrating the relative positions of the first magnet 140 and the second magnet 240.

Referring to FIGS. 1 and 13, when the coupling nut 130 rotates, the first magnet 140 also rotates together. Accordingly, when viewed from the second magnet 240 of the adaptor 200, the polarity of the facing first magnet 140 changes in conjunction with the rotation of the coupling nut 130 at any given point in the circumferential direction of the second magnet 240.

Thus, when the user rotates the coupling nut 130, if the first pole N of the first magnet 140 and the second pole S of the second magnet 240 are aligned in the circumferential direction, as shown in (a) of FIG. 13, the plug 100 and the connector are coupled to each other by the attractive force between the first magnet 140 and the second magnet 240.

Conversely, when the user rotates the coupling nut 130, if the first pole N of the first magnet 140 and the first pole N of the second magnet 240 are aligned in the circumferential direction, as shown in (b) of FIG. 13, the plug 100 and the connector are separated by the repulsive force between the first magnet 140 and the second magnet 240.

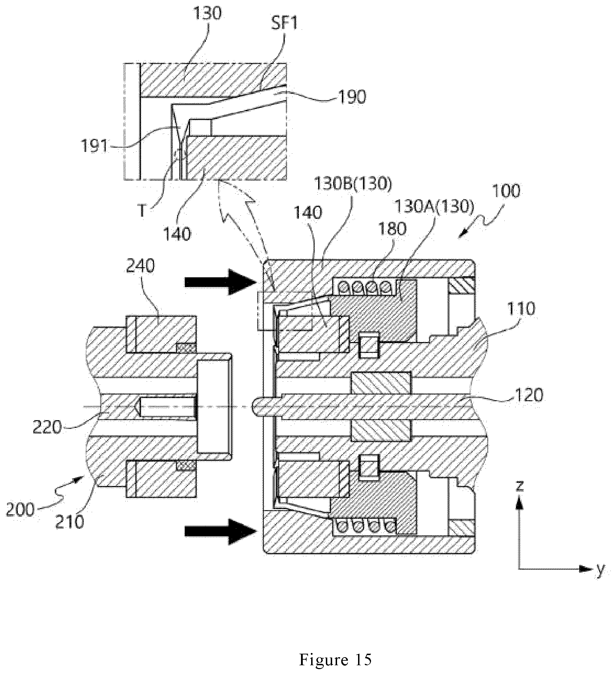

FIG. 14 is a side cross-sectional view of a connector assembly including a separation leading portion; and FIG. 15 is a side cross-sectional view of the connector assembly in which the plug 100 and the adaptor 200 are uncoupled by the separation leading portion.

Referring to FIGS. 14 and 15, the coupling nut 130 may be divided into an inner part 130A and an outer part 130B. The inner part 130A is rotatably coupled to the outer surface of the first body 110. The outer part 130B is disposed outside the inner part 130A and is slidably coupled to the inner part 130A in the axial direction. When the user rotates the outer part 130B around the axial center, both the outer part and the inner part 130A rotate together. Since the first magnet 140 is fixed to the inner part 130A, the first magnet 140 also rotates together.

The plug 100 includes an elastic member 180 disposed between the outer part 130B and the inner part (130A) in the axial direction, which provides a restoring force when compressed. A portion of the inner part 130A is located inside the elastic member 180.

Meanwhile, the plug 100 may include a separation leading portion 190. The separation leading portion 190 serves to physically assist in separating the first magnet 140 and the second magnet 240. The separation leading portion 190 is fixed to the front surface of the inner part 130A.

The separation leading portion 190 may include a tip portion 191 at its end. The tip portion 191 protrudes toward the axial center and may be formed with a pointed end. The separation leading portion 190 may be a single member formed in an annular shape, or may be composed of several elastic segments spaced apart from each other in the circumferential direction. The separation leading portion 190 is located inside the elastic member 180 in the radial direction.

The inner surface of the coupling nut 130 may include a first surface in contact with the outer surface of the separation leading portion 190. The first surface may be formed to have an increasing inner diameter as it extends toward the inner part 130A at the rear.

As shown in FIG. 14, if the outer part 130B of the coupling nut 130 is not pulled, the outer part 130B is positioned forward due to the elastic member 180, keeping the first surface and the separation leading portion 190 spaced apart.

As shown in FIG. 15, when the user rotates the outer part 130B to align the first pole N of the first magnet 140 with the first pole N of the second magnet 240, generating a repulsive force between the first magnet 140 and the second magnet 240, and then pulls the outer part 130B, the retreating first surface SF1 presses the separation leading portion 190 toward the axial center. In this way, as the separation leading portion 190 is pressed, the tip portion 191 moves toward the axial center and penetrates into the space between the first magnet 140 and the second magnet 240, making it easier to separate the first magnet 140 and the second magnet 240.

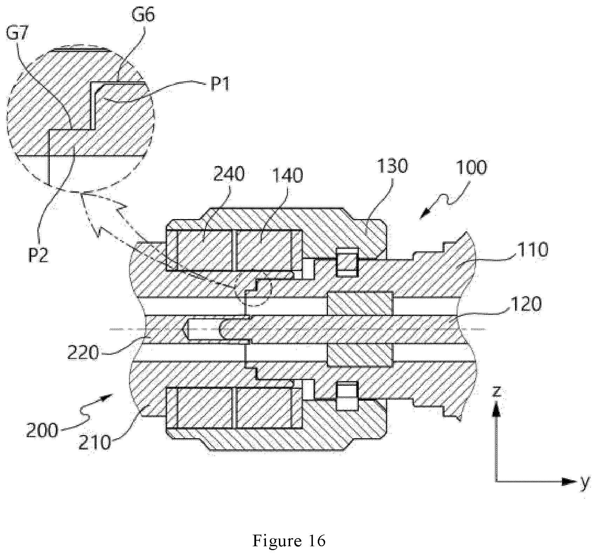

FIG. 16 is a side cross-sectional view of a connector assembly including a plug 100 and an adaptor 200 that form the multi-step coupling relationship.

Referring to FIG. 16, the plug 100 and the adaptor 200 form a multi-step coupling relationship, thereby improving the coupling force and shielding performance of the plug 100 and the adaptor 200.

When the plug 100 and the adaptor 200 are coupled, the first protrusion portion P1 of the plug 100 is inserted into the sixth groove G6 of the adaptor 200.

The plug 100 may include a second protrusion portion P2 that protrudes forward in a stepped manner from the first protrusion portion P1.

The adaptor 200 may include a seventh groove G7 that is recessed in a stepped manner from the sixth groove G6.

When the plug 100 and the adaptor 200 are coupled, the second protrusion portion P2 of the plug 100 is inserted into the seventh groove G7 of the adaptor 200.

In this way, when the first body 110 of the plug 100 and the second body 210 of the adaptor 200 are coupled with an overlapping multi-step structure, the contact area increases, thereby enhancing the coupling force and shielding performance.

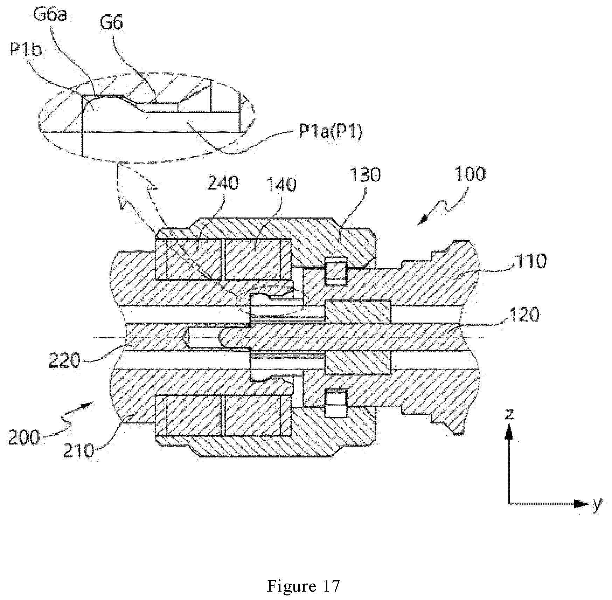

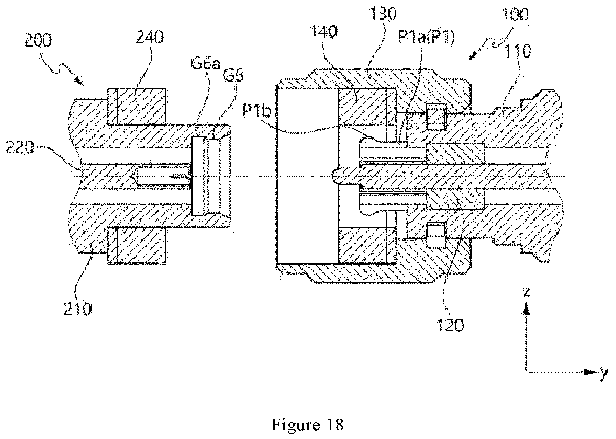

FIG. 17 is a side cross-sectional view of a connector assembly including a plug 100 and an adaptor 200 that form the coupling relationship of a tension structure included in the plug 100; and FIG. 18 is a view showing the connector assembly shown in FIG. 17, depicting the plug 100 and the adaptor 200 before coupling.

Referring to FIGS. 17 and 18, the coupling relationship between the plug 100 and the adaptor 200 may include coupling by the tension structure included in the plug 100.

The first protrusion portion P1 of the plug 100 may be comprised of a plurality of first elastic segments P1a spaced apart from each other in the circumferential direction.

The first elastic segment P1a may include a locking protrusion P1b that projects outward at its end.

The adaptor 200 may include a locking groove G6a that engages with the locking protrusion P1b. The locking groove G6a is recessed outward from the inner surface of the sixth groove G6.

When the plug 100 and the adaptor 200 are coupled, the first elastic segments P1a contract and enter the sixth groove G6, and after entering, the locking protrusions P1b engage with the locking groove G6a. Since the locking protrusion P1b and the locking groove G6a are constrained to each other in the axial direction, the coupling force between the plug 100 and the adaptor 200 can be increased.

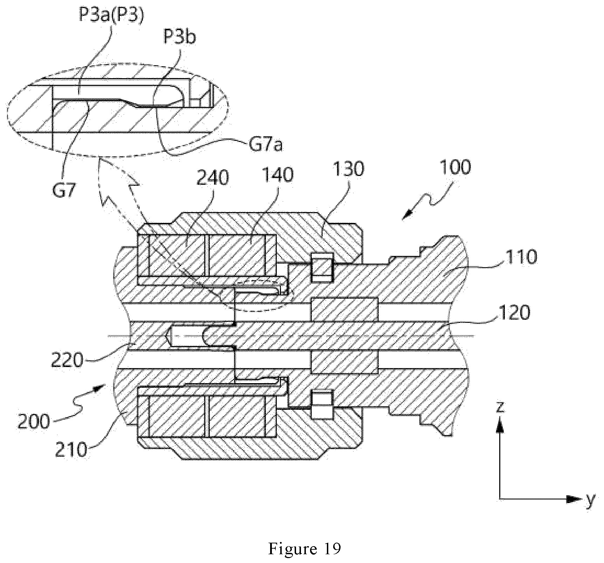

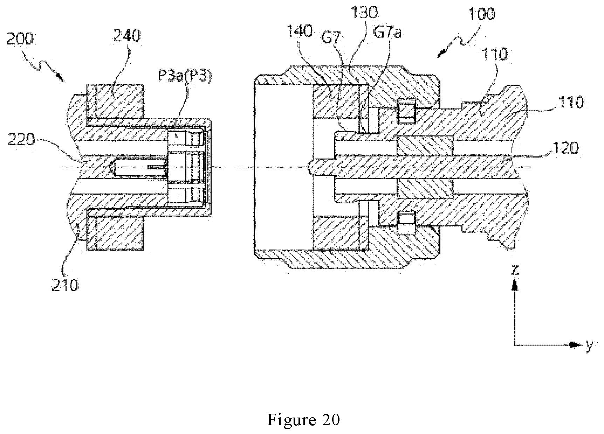

FIG. 19 is a side cross-sectional view of a connector assembly including a plug 100 and an adaptor 200 that form a coupling relationship of a tension structure included in the adaptor 200; and FIG. 20 is a view showing the connector assembly shown in FIG. 19, depicting the plug 100 and adaptor 200 before coupling.

Referring to FIGS. 19 and 20, the coupling relationship between the plug 100 and the adaptor 200 may include coupling by the tension structure included in the adaptor 200.

The second body 210 may include a third protrusion portion P3. The third protrusion P3 protrudes from the front surface of the second body 210.

The third protrusion portion P3 may be comprised of a plurality of second elastic segments P3a spaced apart from each other in the circumferential direction.

The second elastic segment P3a may include a locking protrusion P3b that projects inward at its end.

The first body 110 of the plug 100 may include a seventh groove G7. The third protrusion portion P3 is inserted into the seventh groove G7. The seventh groove G7 may include a locking groove G7a that engages with the locking protrusion P3b. The locking groove G7a is recessed outward from the inner surface of the seventh groove G7.

When the plug 100 and the adaptor 200 are coupled, the first elastic segments P1a expand and enter the seventh groove G7, and after entering, the locking protrusions P3b engage with the locking groove G7a. Since the locking protrusion P3b and the locking groove G7a are constrained to each other in the axial direction, the coupling force between the plug 100 and the adaptor 200 can be increased.

The plug and cable for an RX coaxial cable, according to the exemplary embodiment of the present invention, and the RF connector assembly including the same have been described in detail with reference to the accompanying drawings.

It should be understood that the above-described embodiments of the present invention are provided only as examples in all aspects and are not limited. The scope of the present invention is defined according to the appended claims rather than the above detailed description. Additionally, the meaning and scope of the appended claims as well as all the modifications and modified forms that are drawn from the meaning and scope of the appended claims should be interpreted as being included in the scope of the present invention.

### INDUSTRIAL APPLICABILITY

The present invention can be efficiently applied in the field of manufacturing plugs and connectors of RF coaxial cables.

## Claims

1. A plug for a radio frequency (RF) coaxial cable to which an RF coaxial cable is coupled comprising:
a first body in which the RF coaxial cable is inserted;
a first conductor disposed in the first body;
a coupling nut which is arranged on the outside of the first body and rotatably coupled to the first body; and
a first magnet of an annular shape which is fixed in the coupling nut and rotated along with the coupling nut,
wherein the first magnet has a first pole and a second pole having different polarities which are alternately arranged in the circumferential direction.

2. The plug of claim 1, wherein
the first magnet comprises a first groove disposed at a boundary between the first pole and the second pole and
the first groove is disposed on an outer peripheral surface of the first magnet and extends to a front surface of the first magnet.

3. The plug of claim 1, further comprising a first shield member of an annular shape, wherein the first shield member is in contact with a rear surface of the first magnet.

4. The plug of claim 3, wherein the coupling nut comprises a first step disposed on an inner surface thereof and a rear surface of the first shield member is in contact with the first step.

5. The plug of claim 1, wherein
the first magnet comprises a second groove disposed on an edge formed between a front surface of the first magnet and an outer peripheral surface of the first magnet and further comprises a first press-fit ring disposed in the second groove, and
an inner peripheral surface of the first press-fit ring is in contact with the first magnet while an outer peripheral surface of the first press-fit ring is in contact with an inner peripheral surface of the coupling nut, thereby fixing the first magnet to the coupling nut.

6. The plug of claim 1, wherein
the first magnet comprises a first hole that penetrates through a front surface of the first magnet and a rear surface of the first magnet,
the coupling nut comprises a third groove disposed on an inner surface of the coupling nut and arranged in alignment with the first hole, and
a first press-fit ring is press-fit into the first hole and the third groove, thereby fixing the first magnet to the coupling nut.

7. An adaptor for a radio frequency (RF) coaxial cable to which an RF coaxial cable is coupled, the adaptor comprising:
a second body;
a second conductor disposed in the second body; and
a second magnet of an annular shape fixed to the outside of the second body,
wherein the second magnet has a first pole and a second pole having different polarities which are alternately arranged in the circumferential direction.

8. The adaptor of claim 7, wherein
the second magnet comprises a third groove disposed at a boundary between the first pole and the second pole and
the third groove is disposed on an outer peripheral surface of the second magnet and extends to a front surface of the second magnet.

9. The adaptor of claim 7, further comprising a second shield member of an annular shape, wherein the second shield member is in contact with a rear surface of the second magnet.

10. The adaptor of claim 9, wherein the body comprises a second step and
a rear surface of the second shield member is in contact with the second step.

11. The adaptor of claim 7, wherein
the second magnet comprises a fourth groove disposed on an edge formed between a front surface of the second magnet and an inner peripheral surface of the second magnet and further comprises a second press-fit ring disposed in the fourth groove, and
an inner peripheral surface of the second press-fit ring is in contact with the second body while an outer peripheral surface of the second press-fit ring is in contact with an inner peripheral surface of the second magnet, thereby fixing the second magnet to the second body.

12. The adaptor of claim 7, wherein
the second magnet comprises a second hole that penetrates through front and rear surfaces of the second magnet,
the second body comprises a fifth groove arranged in alignment with the second hole, and
a second press-fit ring is press-fit into the second hole and the fifth groove, thereby fixing the second magnet to the second body.

13. A radio frequency (RF) connector assembly, comprising:
the plug of any one of claims 1 to 6; and
the adaptor of any one of claims 7 to 12,
wherein when the plug and the adaptor are coupled,
the first magnet and the second magnet are arranged to face each other,
and with the rotation of the coupling nut,
when the first pole of the first magnet and the second pole of the second magnet are aligned in the circumferential direction, the plug and the adaptor are coupled by an attractive force between the first magnet and the second magnet, and
when the first pole of the first magnet and the first pole of the second magnet are aligned in the circumferential direction, the plug and the adaptor may are separated by a repulsive force between the first magnet and the second magnet.

14. The RF connector assembly of claim 13, wherein in the plug,
the coupling nut comprises an inner part rotatably coupled to an outer surface of the first body and an outer part disposed outside the inner part and slidably coupled to the inner part in a front and rear direction,
the plug comprises a separation leading portion which is elastically deformably fixed to the inner part and comprises a tip portion aligned between the first magnet and the second magnet in the front and rear direction,
the separation leading portion is disposed so as to contact an inner surface of the outer part that slides, and
when the coupling nut moves rearward, the coupling nut pushes the separation leading portion, causing the tip portion to move in the radial direction, so that the tip portion is inserted between the first magnet and the second magnet in the front and rear direction, thereby separating the first magnet and the second magnet.

15. The RF connector assembly of claim 14, wherein
the plug further comprises an elastic member disposed between the outer part and the inner part in the front and rear direction, which provides a restoring force when compressed,
when the coupling nut is pulled rearward, the elastic member remains compressed and provides a restoring force, pushing the separation leading portion to move the tip portion between the first magnet and the second magnet, and
when the coupling nut is pulled rearward and then released, the separation leading portion returns to its position before elastic deformation due to the restoring force.

16. The RF connector assembly of claim 15, wherein
an inner surface of the coupling unit comprises a first surface in contact with the separation leading portion,
the first surface is formed to have an inner diameter that increases toward the rear, and
the separation leading portion is disposed inside the elastic member in the radial direction.

17. The RF connector assembly of claim 13, wherein the second body comprises a sixth groove which is recessed from a front surface of the second body, and the first body comprises a first protrusion portion which is inserted into the sixth groove.

18. The RF connector assembly of claim 17, wherein the RF connector assembly comprises a seventh groove recessed from the sixth groove and a second protrusion portion which protrudes from the first protrusion portion and is inserted into the seventh groove.

19. The RF connector assembly of claim 17, wherein
the first protrusion portion is composed of a plurality of first elastic segments spaced apart from each other in the circumferential direction,
each of the plurality of first elastic segments comprises a locking protrusion protruding in the radial direction, and
an inner surface of the sixth groove comprises a locking groove that engages with the locking protrusion.

20. The RF connector assembly of claim 13, wherein the second body comprises a third protrusion portion protruding from a front surface of the second body,
the first body comprises a seventh groove recessed from a front surface of the first body, and
the third protrusion portion is composed of a plurality of second elastic segments that are spaced apart from each other in the circumferential direction and inserted into the seventh groove.
